# EUROPÄISCHE PATENTANMELDUNG

(11) **EP 3 675 153 A1**
(43) Veröffentlichungstag der Anmeldung: **01.07.2020**
(21) Anmeldenummer: 19196401.4
(22) Anmeldetag: 10.09.2019
(51) Int. Cl.: H01L 21/60, B23K 1/00

(54) **VERFAHREN ZUM HERSTELLEN EINES SUBSTRATADAPTERS UND SUBSTRATADAPTER ZUM VERBINDEN MIT EINEM ELEKTRONIKBAUTEIL**

(30) Priorität: 06.12.2018 DE 102018221148
(71) Anmelder: Heraeus Deutschland GmbH & Co KG, 63450 Hanau (DE)
(72) Erfinder: Klein, Andreas Steffen, 63450 Hanau (DE); Hinrich, Andreas, 63450 Hanau (DE); Schäfer, Michael, 63450 Hanau (DE); Löwer, Yvonne, 63450 Hanau (DE); Schmitt, Wolfgang, 63450 Hanau (DE); Lemmer, Michael, 63450 Hanau (DE)
(74) Vertreter: Heraeus IP

(57) **Zusammenfassung**

Die vorliegende Erfindung betrifft ein Verfahren zum Herstellen eines Substratadapters zum Verbinden mit einem Elektronikbauteil, aufweisend die Schritte:
Anordnen zumindest einer Kontaktierungsmaterial-Schicht (5) zwischen zumindest einer Seite eines Trägers (9) und einer Oberfläche eines Substrats (3) derart, dass die Kontaktierungsmaterial-Schicht (5) zumindest eine Sollbruchstelle aufweist; und
Fügen des Trägers (9) und des Substrats (3) mit der Kontaktierungsmaterial-Schicht (5).

Auch betrifft die vorliegende Erfindung einen Substratadapter zum Verbinden mit einem Elektronikbauteil.

## Beschreibung

Die vorliegende Erfindung betrifft ein Verfahren zum Herstellen eines Substratadapters. Weiterhin betrifft die vorliegende Erfindung einen Substratadapter zum Verbinden mit einem Elektronikbauteil.

Substratadapter sind aus dem Stand der Technik bekannt und werden in der Leistungselektronik eingesetzt. Diese Substratadapter sind gewöhnlich als Verbundmaterialen ausgestaltet, die ein Kontaktierungsmaterial in Form einer porösen oder spröden Schicht, beispielsweise eine sinterbare Schicht oder eine Klebstoffschicht umfassen. Diese poröse oder sinterbare Schicht wird, wie es aus dem Stand der Technik bekannt ist, zunächst auf ein Substrat oder einen Träger, beispielsweise einer Trägerfolie aufgebracht und danach werden diese Schichten zu einem Schichtverbund zusammengefügt. In der DE 10 2011 083 926 A1 wird beispielsweise ein Schichtverbund aus einer Trägerfolie und einer Schichtanordnung umfassend eine poröse oder sinterbare Schicht und eine Lotschicht beschrieben. Die poröse oder sinterbare Schicht kann auf Elektronikbauteile oder elektronische Bauteile angefügt werden, um dadurch verbesserte Verbindungen zwischen verschiedenen Elektronikbauteilen zu ermöglichen. In einem solchen Verfahren wird die Schichtanordnung von der Trägerfolie abgehoben und die poröse oder sinterbare Schicht wird auf das Elektronikbauteil aufgebracht.

Weiterhin beschreibt die DE 10 2009 018 541 A1 ein Kontaktierungsmittel für Elektronikbauteile mit einer porösen oder sinterbaren Schicht mit gedruckten metallischen Verbindungsstrukturen.

Allerdings haben die aus dem Stand der Technik bekannten Lösungen den Nachteil, dass es beim Ablösen der porösen oder sinterbaren Schichten zu unkontrollierten Ausbrüchen innerhalb der Schichten kommen kann. Außerdem wirkt sich das unkontrollierte Ausbrechen negativ auf die Produktionsausbeute und die Produktqualität des entstehenden Produkts aus, da Ausschuss entsteht oder fehlerhafte Teile weiter prozessiert werden.

Aufgabe der vorliegenden Erfindung ist es daher, ein verbessertes Verfahren zum Herstellen eines Substratadapters und einen Substratadapter bereitzustellen, das/der die Nachteile des Stands der Technik überwindet. Insbesondere ein Ausbrechen der Kontaktierungsmaterial-Schicht zu verhindern, so dass das Ablösen der Bauteile reproduzierbar und mit einer gleichen Qualität erfolgen kann, um damit eine robusten Bestückungsprozess und eine hohe Produktionsausbeute zu ermöglichen.

Diese Aufgabe wird erfindungsgemäß durch ein Verfahren zum Herstellen eines Substratadapters gemäß des Gegenstands des Patentanspruchs 1 gelöst.

Das erfindungsgemäße Verfahren zum Herstellen eines Substratadapters zum Verbinden mit einem Elektronikbauteil weist die folgenden Schritte auf:
Anordnen zumindest einer Kontaktierungsmaterial-Schicht zwischen zumindest einer Seite eines Trägers und einer Oberfläche eines Substrats derart, dass die Kontaktierungsmaterial-Schicht zumindest eine Sollbruchstelle aufweist; und
Fügen des Trägers und des Substrats mit der Kontaktierungsmaterial-Schicht.

Bei dem Substrat kann es sich um ein Metallblech oder um einen Metallbandabschnitt, insbesondere um ein Kupferblech oder um einen Kupferbandabschnitt, handeln. Als Kupferblech ist auch ein Blech zu verstehen, das aus einem Kupferlegierungsmaterial besteht. Bei einem Kupferbandabschnitt kann es sich um einen derartigen Bandabschnitt handeln, der aus einem Kupferlegierungsmaterial besteht. Des Weiteren ist es möglich, dass das Substrat ein Leadframe oder ein DCB-Substrat oder ein PCB-Substrat ist. Vorzugsweise ist das Metallblech oder der Metallbandabschnitt, insbesondere das Kupferblech oder der Kupferbandabschnitt, nicht vorstrukturiert. Lediglich eine Ablängung und/oder Strukturierung der Seitenränder kann bei dem zu verwendenden Substrat durchgeführt worden sein.

Das Substrat kann auf mindestens einer Seite, insbesondere mit einem Material, das Gold (Au) oder Nickel-Gold (NiAu) oder Silber (Ag) oder Nickel-Silber (NiAg) oder Nickel-Palladium-Gold (NiPdAu) umfasst, beschichtet, insbesondere galvanisiert sein. Außerdem ist es möglich, dass das Material auf mindestens einer Seite des Substrats chemisch abgeschieden wird. Vorzugsweise wird das Substrat, insbesondere mit den genannten Materialien, auf mindestens der Seite beschichtet, die später kontaktiert werden soll. Außerdem ist es denkbar, dass beide Seiten des Substrats beispielsweise mit den vorgenannten Materialien beschichtet werden.

Die Kontaktierungsmaterial-Schicht, die eine Sinterpaste, insbesondere eine silberhaltige Sinterpaste, oder ein Lot oder ein Leitkleber oder eine Klebefolie sein kann, dient zum tatsächlichen Verbinden des Substrats mit dem Elektronikbauteil.

Bei dem Träger kann es sich beispielsweise um eine Trägerfolie, insbesondere um eine Trägerfolie mit geringer Adhäsionskraft, handeln. Des Weiteren ist es möglich, zum Herstellen eines Trägers einen Wafer-Frame mit UV-Tape zu bespannen. Das mit einer Schicht des Kontaktierungsmaterials versehene Substrat kann auf dieses UV-Tape geklebt werden. Alternativ hierzu kann die Kontaktierungsmaterial-Schicht auch auf den Träger aufgetragen werden und das Substrat auf der Kontaktierungsmaterial-Schicht angeordnet werden. Der Träger dient dazu, dass der Substratadapter von einer ersten Produktionsstätte zu einer weiteren Produktionsstätte bzw. von einer ersten Fertigungsvorrichtung zu einer weiteren Fertigungsvorrichtung transportiert werden kann.

Erfindungsgemäß weist die Kontaktierungsmaterial-Schicht zumindest eine Sollbruchstelle auf. Als "Sollbruchstelle" kann in diesem Zusammenhang ein Bereich in der bzw. an der Kontaktierungsmaterial-Schicht verstanden werden, der bei Überlast gezielt und vorhersagbar versagt und hierdurch die Kontaktierungsmaterial-Schicht kontrolliert entlang dieser Sollbruchstelle getrennt wird. Diese Sollbruchstelle kann sich in einer Fläche oder in einem Flächenabschnitt in der Kontaktierungsmaterial-Schicht befinden, die/der sich insbesondere parallel zur Oberfläche des Substrats erstreckt.

Die Sollbruchstelle kann beispielsweise gebildet sein aus Materialaussparungen in einer Fläche der Kontaktierungsmaterial-Schicht oder dem Einbringen, insbesondere dem flächigen Einbringen von einer, beispielsweise im Physikalischen Gasphasenabscheidungs, PVD, Verfahren hergestellten, Trennschicht in der Kontaktierungsmaterial-Schicht.

Mit der Erfindung ist es erstmalig gelungen, unkontrollierte Ausbrüche innerhalb der Kontaktierungsmaterial-Schicht beim Ablösen von dem Träger stark zu reduzieren, bzw. zu verhindern. Vorteilhaft kann hierdurch die Produktionsausbeute und die Produktqualität des entstehenden Produkts gesteigert werden, da weder Ausschuss entsteht noch fehlerhafte Teile weiter prozessiert werden.

In einem Beispiel weist das Anordnen der Kontaktierungsmaterial-Schicht auf:
Anordnen der Kontaktierungsmaterial-Schicht mit mindestens einer Materialaussparung in der Kontaktierungsmaterial-Schicht, vorzugsweise mit einer Vielzahl von Materialaussparungen, um die Sollbruchstelle zu bilden, insbesondere wobei die Materialaussparrungen auf einer Oberfläche der Kontaktierungsmaterial-Schicht angeordnet sind und/oder dem Träger zugewandt sind.

Die Materialaussparungen können durch einen Bereich in der Kontaktierungsmaterial-Schicht gebildet sein, der im Wesentlichen parallel zu dem Substrat verläuft und in dessen flächenmäßigen Verlauf weniger als 50 % Kontaktierungsmaterial angeordnet ist. Weiterhin kann der Bereich mit den Materialaussparungen auf einer dem Träger zugewandten Oberfläche der Kontaktierungsmaterial-Schicht ausgebildet sein, so dass der Träger nicht vollflächig von der Kontaktierungsmaterial-Schicht bedeckt ist.

In einem Beispiel weist das Anordnen der Kontaktierungsmaterial-Schicht auf:
Anordnen der Kontaktierungsmaterial-Schicht zumindest bereichsweise in Form von dreidimensionalen Strukturen, insbesondere in Form von pyramidenförmigen, kugelförmigen, würfelförmigen, torusförmigen, zylinderförmigen, und/oder kegelförmigen Strukturen, wobei die Materialaussparung, vorzugsweise die Materialaussparungen, aus mindestens einem Zwischenraum zwischen benachbarten dreidimensionalen Strukturen gebildet wird/werden.

Beispielsweise kann ein erster Teil der Kontaktierungsmaterial-Schicht in Form einer im Wesentlichen ebenen Schicht bereitgestellt werden und ein zweiter Teil der Kontaktierungsmaterial-Schicht kann auf dieser Schicht in Form der oben beschriebenen dreidimensionalen Strukturen angeordnet werden.

In einem Beispiel weist das Anordnen der Kontaktierungsmaterial-Schicht auf:
Anordnen, insbesondere gleichmäßig beabstandetes Anordnen, der dreidimensionalen Strukturen entlang einer ersten Ausdehnungsachse, vorzugsweise entlang der ersten Ausdehnungsachse und einer zweiten Ausdehnungsachse, insbesondere wobei die erste und
die zweite Ausdehnungsachse in einem Winkel von im Wesentlichen 90° zueinander angeordnet sind.

Bevorzugt sind die dreidimensionalen Strukturen gleichmäßig über die Oberfläche der Schicht aus Kontaktierungsmaterial verteilt, um hierdurch ein gleichmäßiges und kontrolliertes Ablösen der Kontaktierungsmaterial-Schicht von dem Träger zu ermöglichen.

In einem weiteren Beispiel weist das Anordnen der Kontaktierungsmaterial-Schicht auf: Anordnen der Kontaktierungsmaterial-Schicht auf dem Träger durch Drucken, insbesondere durch Siebdrucken, Aufsprühen, und/oder Rakeln, und/oder
Anordnen der Kontaktierungsmaterial-Schicht auf dem Träger durch Verprägen, insbesondere durch Verprägen mittels eines Stempels und/oder einer Profilwalze.

In diesem Beispiel kann eine im Wesentlichen gleichmäßige Schicht des Kontaktierungsmaterials zunächst auf den Träger oder auf das Substrat gedruckt werden und danach dreidimensionale Strukturen, zur Realisierung der Sollbruchstelle, auf die Schicht aufgedruckt werden, oder mittels einer Profilwalze in der Schicht ausgebildet werden.

Die Kontaktierungsmaterial-Schicht wird vorzugsweise vollflächig, bzw. nahezu vollflächig, auf den Träger oder auf das Substrat aufgebracht. Beispielsweise kann mindestens ein Substrat zum Aufbringen der Kontaktierungsmaterial-Schicht in einem Drucknest positioniert werden. Es ist möglich, dass mehrere Substrate in einem Drucknest positioniert werden. Des Weiteren ist es möglich, dass das Kontaktierungsmaterial zur Bildung einer Kontaktierungsmaterial-Schicht durch ein Sprühverfahren aufgebracht wird. Jedoch ist auch ein Aufbringen mittels eines Rakelverfahrens möglich.

In einem Beispiel umfasst der Träger zumindest eine Klebeschicht, insbesondere eine Klebeschicht mit einer im Wesentlichen gleichbleibenden Klebekraft über die Oberfläche des Trägers.

Vorteilhaft können hierdurch die dreidimensionalen Strukturen der Sollbruchstelle besonders zuverlässig mit dem Träger verbunden werden und somit während des Transportes der Anordnung zwischen verschiedenen Produktionsstätten nicht verrutschen. Weiterhin vorteilhaft unterstützt die Klebeschicht ein kontrolliertes Ablösen der Kontaktierungsmaterial-Schicht von dem Träger.

In noch einem Beispiel umfasst die Kontaktierungsmaterial-Schicht einen Kleber, ein Lot und/oder ein Sintermaterial, insbesondere eine Sinterpaste und/oder eine Sinterfolie, die vorzugsweise Silber, eine Silberlegierung, Kupfer, und/oder einer Kupferlegierung umfasst/umfassen.

In einem Beispiel weist das Verfahren auf:
Ablösen des Substratadapters, insbesondere mit einer Greif- oder Ansaugvorrichtung, im Wesentlichen entlang der Sollbruchstelle zwischen der Kontaktierungsmaterial-Schicht und dem Träger.

Das Ablösen des Substrats zusammen mit der aufgebrachten Kontaktierungsmaterial-Schicht von dem Träger kann mit Hilfe einer Düse erfolgen. Im Rahmen eines Pick-and-Place-Prozesses kann das Substrat zusammen mit der aufgebrachten Kontaktierungsmaterial-Schicht entlang der Sollbruchstelle von dem Träger gelöst werden und auf dem Elektronikbauteil aufgebracht werden. Dies kann in einem Schritt erfolgen, d.h. nach dem Ablösen vom Träger kann das Substrat sofort auf dem Elektronikbauteil aufgesetzt werden. Des Weiteren ist es möglich, dass das Ablösen vom Träger und das Aufsetzen des Substrats zusammen mit der Kontaktierungsmaterial-Schicht auf dem Elektronikbauteil in zwei separaten Schritten und somit möglicherweise mit zwei unterschiedlichen Düsen durchgeführt wird.

Bei dem Elektronikbauteil kann es sich um einen Halbleiter oder um ein DCB-Substrat oder um ein PCB-Substrat handeln. Das Verbinden der Substratanordnung mit dem Elektronikbauteil kann beispielsweise mittels Versintern und/oder Verpressen und/oder Verlöten und/oder Verkleben erfolgen. Mit anderen Worten wird die Substratanordnung mit dem Elektronikbauteil versintert und/oder verpresst und/oder verlötet und/oder verklebt. Vorzugsweise wird die Substratanordnung mit dem Elektronikbauteil versintert.

In einem weiteren Beispiel weist das Verfahren auf:
Vereinzeln des mit der Kontaktierungsmaterial-Schicht zusammengefügten Substrats und des Trägers nach dem Fügen des Trägers und des Substrats mit der Kontaktierungsmaterial-Schicht, insbesondere Unterteilen, vor dem Ablösen des mit der Kontaktierungsmaterial-Schicht zusammengefügten Substrats, in zumindest zwei mit Teilen der Kontaktierungsmaterial-Schicht zusammengefügten Formteile des Substrats, insbesondere in eine Vielzahl von Formteile mittels Sägen, Schneiden, Stanzen und/oder Ätzen.

Nach dem Fügen des Trägers und des Substrats mit der Kontaktierungsmaterial-Schicht kann das Substrat vereinzelt werden.

Des Weiteren ist es möglich, dass mehrere Substratanordnungen aus einer zunächst größeren Substratanordnung durch Vereinzeln hergestellt werden. Auch ein Strukturieren des Substrats, beispielsweise zur Anpassung des Substrats bzw. der Substratanordnung an die Geometrie des zu verbindenden Bauteils, ist möglich.

Vorzugsweise erfolgen das Abtrennen des seitlichen Rands und/oder das Strukturieren des Substrats und/oder das Vereinzeln des Substrats mittels Laser. Mit Hilfe eines Laserschneidverfahrens können äußerst kleine Bauteile bearbeitet werden. Des Weiteren können sehr scharfe Kanten mit Hilfe eines Laserschneidverfahrens erzeugt werden.

Beim Abtrennen des seitlichen Rands und/oder beim Strukturieren des Substrats und/oder beim Vereinzeln des Substrats, insbesondere in einem mit dem Träger verbundenen Zustand des Substrats, kann bzw. können zumindest abschnittsweise die Kontaktierungsmaterial-Schicht abgetrennt und/oder strukturiert und/oder vereinzelt werden.

In einem Beispiel umfasst das Substrat ein Metallelement, bevorzugt eine Metallfolie, weiter bevorzugt eine Kupferfolie.

Die Erfindung schlägt auch einen Substratadapter zum Verbinden mit einem Elektronikbauteil vor, aufweisend:
einen Träger; ein Substrat, und
eine Kontaktierungsmittel-Schicht, wobei die Kontaktierungsmaterial-Schicht zwischen zumindest einer Seite des Trägers und einer Oberfläche des Substrats angeordnet ist, wobei die Kontaktierungsmaterial-Schicht zumindest eine Sollbruchstelle aufweist, und der Träger und das Substrat mit der Kontaktierungsmaterial-Schicht zusammengefügt sind.

In einem Beispiel weist die Kontaktierungsmaterial-Schicht mindestens einer Materialaussparung in der Kontaktierungsmaterial-Schicht auf, vorzugsweise eine Vielzahl von Materialaussparungen, um die Sollbruchstelle zu bilden, insbesondere ist die Materialaussparung auf einer Oberfläche der Kontaktierungsmaterial-Schicht angeordnet und/oder dem Träger zugewandt.

In einem weiteren Beispiel ist die Kontaktierungsmaterial-Schicht zumindest bereichsweise in Form von dreidimensionalen Strukturen angeordnet, insbesondere in Form von pyramidenförmigen, kugelförmigen, würfelförmigen, torusförmigen, zylinderförmigen, und/oder kegelförmigen Strukturen, wobei die Materialaussparung, vorzugsweise die Materialaussparungen, aus mindestens einem Zwischenraum zwischen benachbarten dreidimensionalen Strukturen gebildet wird/werden.

In einem Beispiel sind die dreidimensionalen Strukturen, insbesondere gleichmäßig beabstandet, entlang einer ersten Ausdehnungsachse, vorzugsweise entlang der ersten Ausdehnungsachse und einer zweiten Ausdehnungsachse angeordnet, insbesondere sind die erste und die zweite Ausdehnungsachse in einem Winkel von im Wesentlichen 90° zueinander angeordnet.

In noch einem Beispiel umfasst der Träger zumindest eine Klebeschicht, insbesondere eine Klebeschicht mit einer im Wesentlichen gleichbleibenden Klebekraft über die Oberfläche des Trägers, und/oder
die Kontaktierungsmaterial-Schicht umfasst einen Kleber, ein Lot und/oder ein Sintermaterial, insbesondere eine Sinterpaste und/oder eine Sinterfolie, die vorzugsweise Silber, eine Silberlegierung, Kupfer, und/oder einer Kupferlegierung umfasst/umfassen.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigen:
- Figuren 1a-d: schematische Schnittansichten eines aus dem Stand der Technik bekannten Substratadapters;
- Figuren 2a-d: schematische Schnittansichten eines Substratadapters gemäß einer Ausführungsform der Erfindung; und
- Figuren 3a-c: isometrische Ansichten von dreidimensionalen Strukturen gemäß Ausführungsformen der Erfindung.

Im Folgenden werden für gleiche und gleichwirkende Teile gleiche Bezugsziffern verwendet.

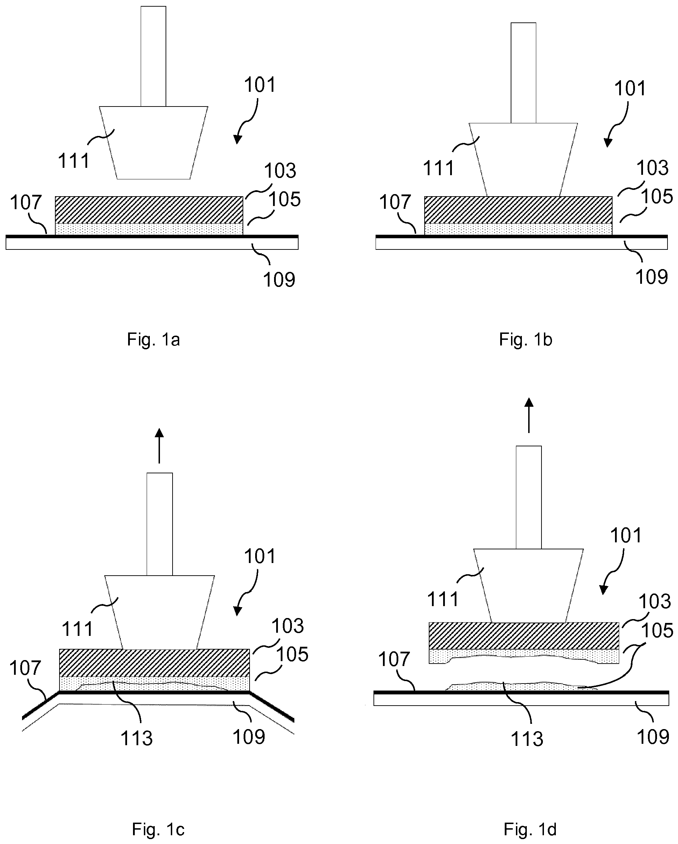

Die Figuren 1a-d zeigen schematische Schnittansichten eines aus dem Stand der Technik bekannten Substratadapters 101. Wie es in Figur 1a gezeigt wird, umfasst der Substratadapter 101 eine Kontaktierungsmaterial-Schicht 105, die zwischen einer Seite eines Trägers 109 und einer Oberfläche eines Substrats 103 angeordnet ist. Der in den Figuren 1a-d gezeigte Substratadapter 101 weist zusätzlich eine Klebeschicht 107 auf, die auf dem Träger 109 zwischen dem Träger 109 und der Kontaktierungsmaterial-Schicht 105 angeordnet ist.

Figur 1a zeigt weiterhin eine Düse 111 zum Ablösen des Substrats 103 zusammen mit der aufgebrachten Kontaktierungsmaterial-Schicht 105 von dem Träger 109 im Rahmen eines Pickand-Place-Prozesses.

In Figur 1b ist die Düse 111 in Kontakt mit einer Oberfläche des Substrats 103, die der Kontaktierungsmaterial-Schicht 105 abgewandt ist. Mittels eines Vakuums wird nun das Substrat 103 von dem Träger 109 gelöst, wie es in der Figur 1c gezeigt ist. Der Pfeil über der Düse 111 zeigt die Bewegungsrichtung an. Durch das Anheben bzw. Ablösen des Substrats 103 mit der darauf angeordneten Kontaktierungsmaterial-Schicht 105 kann es bei dem aus dem Stand der Technik bekannten Substratadapter 101 bzw. Verfahren dazu führen, dass es beim Ablösen der meist porösen Kontaktierungsmaterial-Schicht 105 zu unkontrollierten Ausbrüchen innerhalb der Kontaktierungsmaterial Schicht 105 kommt. Dies wird in Figur 1c durch eine Bruchlinie 113 in dem Material der Kontaktierungsmaterial-Schicht 105 gezeigt. In Figur 1d ist das von dem Träger 109 abgelöste Substrat 103 mit der ausgebrochenen Kontaktierungsmaterial-Schicht 105 gezeigt.

Das unkontrollierte Ausbrechen wirkt sich im Allgemeinen negativ auf die Produktionsausbeute und die Produktqualität des entstehenden Produkts aus, da Ausschuss entsteht und/oder fehlerhafte Teile weiter prozessiert werden.

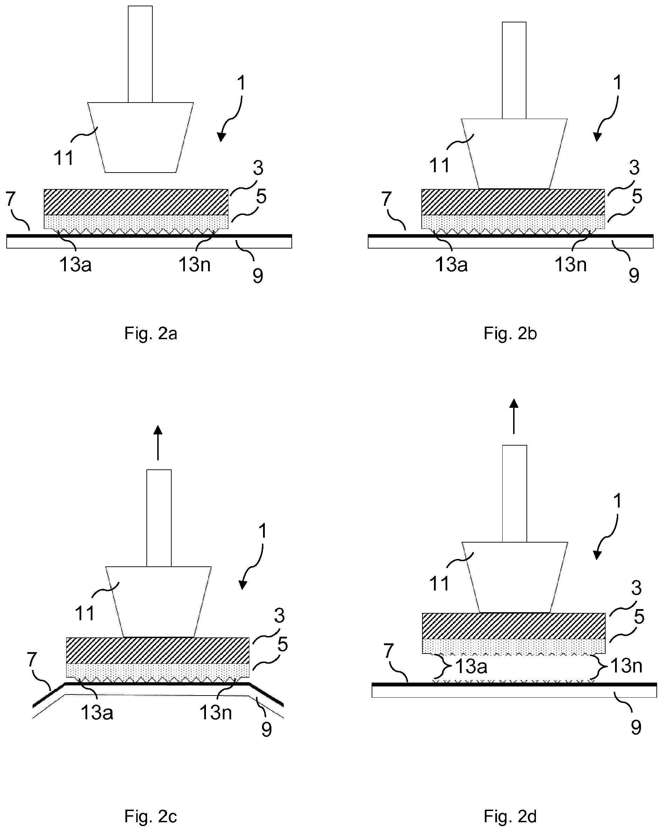

Die Figuren 2a-d zeigen schematische Schnittansichten eines Substratadapters 1 gemäß einer Ausführungsform der Erfindung.

Auch der in Figur 2a gezeigte Substratadapter 1 umfasst eine Kontaktierungsmaterial-Schicht 5, die zwischen einer Seite eines Trägers 9 und einer Oberfläche eines Substrats 3 angeordnet ist.

Die Kontaktierungsmaterial-Schicht 5 kann einen Kleber, ein Lot und/oder ein Sintermaterial umfassen, insbesondere eine Sinterpaste und/oder eine Sinterfolie, die vorzugsweise Silber, eine Silberlegierung, Kupfer, und/oder einer Kupferlegierung umfasst/umfassen. Bei dem Substrat 3 kann es sich um ein Metallblech oder um einen Metallbandabschnitt, insbesondere um ein Kupferblech oder um einen Kupferbandabschnitt, handeln. Als Kupferblech ist auch ein Blech zu verstehen, das aus einem Kupferlegierungsmaterial besteht. Bei einem Kupferbandabschnitt kann es sich um einen derartigen Bandabschnitt handeln, der aus einem Kupferlegierungsmaterial besteht. Des Weiteren ist es möglich, dass das Substrat 3 ein Leadframe oder ein DCB-Substrat oder ein PCB-Substrat ist. Bei dem Träger 9 kann es sich um eine Trägerfolie, insbesondere um eine Trägerfolie mit geringer Adhäsionskraft, handeln. Des Weiteren ist es möglich, zum Herstellen eines Trägers 9 einen Wafer-Frame mit UV-Tape zu bespannen. Das mit der Kontaktierungsmaterial-Schicht 5 versehene Substrat 3 kann auf dieses UV-Tape geklebt werden.

In der gezeigten Ausführungsform ist auf dem Träger 9 eine Klebeschicht 7, insbesondere eine Klebeschicht 7 mit einer im Wesentlichen gleichbleibenden Klebekraft über die Oberfläche des Trägers 9, angeordnet. Diese Klebeschicht 7 ist jedoch nur optional, da das erfindungsgemäße Verfahren/der erfindungsgemäße Substratadapter 1 eine derartige Klebeschicht nicht zwingend benötigen/benötigt.

Die Figur 2a zeigt weiterhin eine Sollbruchstelle in Form von dreidimensionalen Strukturen 13a - 13n, die in der gezeigten Ausführungsform pyramidenförmig ausgestaltet sind. In weiteren Ausführungsformen können die dreidimensionalen Strukturen aber auch pyramidenförmig, kugelförmig, würfelförmig, torusförmig, und/oder kegelförmig ausgestaltet sein. Die Materialaussparungen werden aus den Zwischenräumen zwischen benachbarten dreidimensionalen Strukturen 13a - 13n gebildet. In der gezeigten Ausführungsform sind die Materialaussparungen auf der Klebeschicht 7 angeordnet, um hierdurch ein kontrolliertes Ablösen zu ermöglichen. In nicht gezeigten Ausführungsformen können die Materialaussparrungen aber auch an einer beliebigen Position in der Kontaktierungsmaterial-Schicht angeordnet sein, um ein kontrolliertes Ablösen zu ermöglichen.

Wie bereits in Figur 1b gezeigt, ist auch in Figur 2b die Düse 11 in Kontakt mit einer Oberfläche des Substrats 3, die der Kontaktierungsmaterial-Schicht 5 abgewandt ist. In Figur 2c wird gezeigt, dass mittels eines Vakuums das Substrat 3 von dem Träger 9 gelöst wird. Der Pfeil über der Düse 11 zeigt die Bewegungsrichtung an. Durch das Anheben bzw. Ablösen des Substrats 3 mit der darauf angeordneten Kontaktierungsmaterial-Schicht 5 bricht die Kontaktierungsmaterial-Schicht 5 entlang der Sollbruchstelle ab, wie es in Figur 2d gezeigt ist. Hierdurch werden unkontrollierte Ausbrüche innerhalb der Kontaktierungsmaterial-Schicht 5 beim Ablösen von dem Träger 9 stark reduziert, bzw. verhindert. Vorteilhaft kann hierdurch die Produktionsausbeute und die Produktqualität des entstehenden Produkts gesteigert werden, da weder Ausschuss entsteht noch fehlerhafte Teile weiter prozessiert werden.

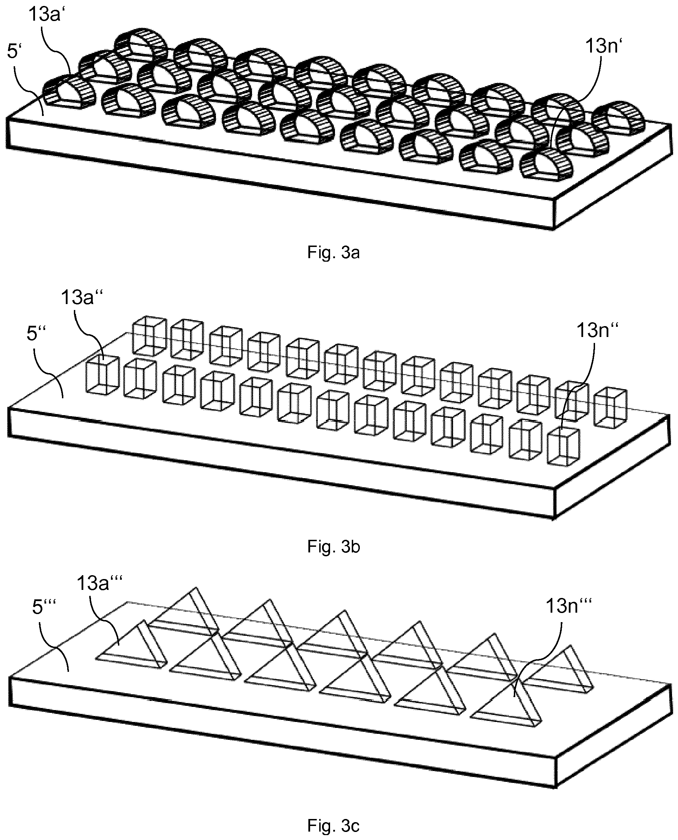

Die Figuren 3a-c zeigen isometrische Ansichten von dreidimensionalen Strukturen 13a' - 13n', 13a" - 13n", 13a'" - 13n'" gemäß Ausführungsformen der Erfindung.

In Figur 3a werden kugelförmige dreidimensionale Strukturen 13a' - 13n' in der Kontaktierungsmaterial-Schicht 5' gezeigt. In Figur 3b werden würfelförmige dreidimensionale Strukturen 13a" - 13n" in der Kontaktierungsmaterial-Schicht 5" gezeigt. In Figur 3a werden pyramidenförmige dreidimensionale Strukturen 13a'" - 13n'" in der Kontaktierungsmaterial-Schicht 5'" gezeigt.

In alternativen Ausführungsformen können aber auch weitere Formen verwendet werden. Weiterhin können auch mehr oder weniger dreidimensionale Strukturen, als gezeigt, in der Kontaktierungsmaterial-Schicht ausgeformt sein. Beispielsweise können in einer Ausführungsform lediglich zwei dreidimensionale Strukturen verwendet werden, um lediglich eine Materialausnehmung als Sollbruchstelle zu schaffen.

Die in der vorstehenden Beschreibung, in den Ansprüchen und in den Figuren dargestellten Merkmale können sowohl einzeln als auch in beliebiger Kombination wesentlich für die Erfindung in ihren verschiedenen Ausführungsformen sein.

### Bezugszeichenliste

- 1: Substratadapter
- 3: Substrat
- 5: Kontaktierungsmaterial-Schicht
- 7: Klebeschicht
- 9: Träger
- 11: Düse
- 13a-13n - 13a'''-13n''': Dreidimensionale Strukturen

### Stand der Technik:

- 101: Substratadapter
- 103: Substrat
- 105: Kontaktierungsmaterial-Schicht
- 107: Klebeschicht
- 109: Träger
- 111: Düse
- 113: Bruchlinie

## Patentansprüche

1. Verfahren zum Herstellen eines Substratadapters zum Verbinden mit einem Elektronikbauteil, aufweisend die Schritte:
Anordnen zumindest einer Kontaktierungsmaterial-Schicht zwischen zumindest einer Seite eines Trägers und einer Oberfläche eines Substrats derart, dass die Kontaktierungsmaterial-Schicht zumindest eine Sollbruchstelle aufweist; und
Fügen des Trägers und des Substrats mit der Kontaktierungsmaterial-Schicht.

2. Das Verfahren nach Anspruch 1, **dadurch gekennzeichnet, dass** das Anordnen der Kontaktierungsmaterial-Schicht aufweist:
Anordnen der Kontaktierungsmaterial-Schicht mit mindestens einer Materialaussparung in der Kontaktierungsmaterial-Schicht, vorzugsweise mit einer Vielzahl von Materialaussparungen, um die Sollbruchstelle zu bilden, insbesondere wobei die Materialaussparrungen auf einer Oberfläche der Kontaktierungsmaterial-Schicht angeordnet sind und/oder dem Träger zugewandt sind.

3. Das Verfahren nach Anspruch 2, **dadurch gekennzeichnet, dass** das Anordnen der Kontaktierungsmaterial-Schicht aufweist:
Anordnen der Kontaktierungsmaterial-Schicht zumindest bereichsweise in Form von dreidimensionalen Strukturen, insbesondere in Form von pyramidenförmigen, kugelförmigen, würfelförmigen, torusförmigen, zylinderförmigen, und/oder kegelförmigen Strukturen, wobei die Materialaussparung, vorzugsweise die Materialaussparungen, aus mindestens einem Zwischenraum zwischen benachbarten dreidimensionalen Strukturen gebildet wird/werden.

4. Das Verfahren nach Anspruch 3, **dadurch gekennzeichnet, dass** das Anordnen der Kontaktierungsmaterial-Schicht aufweist:
Anordnen, insbesondere gleichmäßig beabstandetes Anordnen, der dreidimensionalen Strukturen entlang einer ersten Ausdehnungsachse, vorzugsweise entlang der ersten Ausdehnungsachse und einer zweiten Ausdehnungsachse, insbesondere wobei die erste und die zweite Ausdehnungsachse in einem Winkel von im Wesentlichen 90° zueinander angeordnet sind.

5. Das Verfahren nach einem der vorangehenden Ansprüche, **dadurch gekennzeichnet, dass** das Anordnen der Kontaktierungsmaterial-Schicht aufweist:
Anordnen der Kontaktierungsmaterial-Schicht auf dem Träger durch Drucken, insbesondere durch Siebdrucken, Aufsprühen, und/oder Rakeln, und/oder
Anordnen der Kontaktierungsmaterial-Schicht auf dem Träger durch Verprägen, insbesondere durch Verprägen mittels eines Stempels und/oder einer Profilwalze.

6. Das Verfahren nach einem der vorangehenden Ansprüche, **dadurch gekennzeichnet, dass**
der Träger zumindest eine Klebeschicht, insbesondere eine Klebeschicht mit einer im Wesentlichen gleichbleibenden Klebekraft über die Oberfläche des Trägers umfasst.

7. Das Verfahren nach einem der vorangehenden Ansprüche, **dadurch gekennzeichnet, dass**
die Kontaktierungsmaterial-Schicht einen Kleber, ein Lot und/oder ein Sintermaterial umfasst, insbesondere eine Sinterpaste und/oder eine Sinterfolie, die vorzugsweise Silber, eine Silberlegierung, Kupfer, und/oder einer Kupferlegierung umfasst/umfassen.

8. Das Verfahren nach einem der vorangehenden Ansprüche, **dadurch gekennzeichnet, dass** das Verfahren aufweist:
Ablösen des Substratadapters, insbesondere mit einer Greif- oder Ansaugvorrichtung, im Wesentlichen entlang der Sollbruchstelle zwischen der Kontaktierungsmaterial-Schicht und dem Träger.

9. Das Verfahren nach einem der vorangehenden Ansprüche, aufweisend:
Vereinzeln des mit der Kontaktierungsmaterial-Schicht zusammengefügten Substrats und des Trägers nach dem Fügen des Trägers und des Substrats mit der Kontaktierungsmaterial-Schicht, insbesondere Unterteilen, vor dem Ablösen des mit der Kontaktierungsmaterial-Schicht zusammengefügten Substrats, in zumindest zwei mit Teilen der Kontaktierungsmaterial-Schicht zusammengefügte Formteile des Substrats, insbesondere in eine Vielzahl von Formteile mittels Sägen, Schneiden, Stanzen und/oder Ätzen.

10. Das Verfahren nach einem der vorangehenden Ansprüche, **dadurch gekennzeichnet, dass**
das Substrat ein Metallelement, bevorzugt eine Metallfolie, weiter bevorzugt eine Kupferfolie umfasst.

11. Ein Substratadapter zum Verbinden mit einem Elektronikbauteil, aufweisend:
einen Träger; ein Substrat, und
eine Kontaktierungsmittel-Schicht, wobei die Kontaktierungsmaterial-Schicht zwischen zumindest einer Seite des Trägers und einer Oberfläche des Substrats angeordnet ist, wobei die Kontaktierungsmaterial-Schicht zumindest eine Sollbruchstelle aufweist, und der Träger und das Substrat mit der Kontaktierungsmaterial-Schicht zusammengefügt sind.

12. Der Substratadapter nach Anspruch 11, **dadurch gekennzeichnet, dass** die Kontaktierungsmaterial-Schicht mindestens einer Materialaussparung in der Kontaktierungsmaterial-Schicht aufweist, vorzugsweise eine Vielzahl von Materialaussparungen aufweist, um die Sollbruchstelle zu bilden, insbesondere ist die Materialaussparung auf einer Oberfläche der Kontaktierungsmaterial-Schicht angeordnet und/oder dem Träger zugewandt.

13. Der Substratadapter nach Anspruch 11 oder 12, **dadurch gekennzeichnet, dass** die Kontaktierungsmaterial-Schicht zumindest bereichsweise in Form von dreidimensionalen Strukturen angeordnet ist, insbesondere in Form von pyramidenförmigen, kugelförmigen, würfelförmigen, torusförmigen, zylinderförmigen, und/oder kegelförmigen Strukturen, wobei die Materialaussparung, vorzugsweise die Materialaussparungen, aus mindestens einem Zwischenraum zwischen benachbarten dreidimensionalen Strukturen gebildet wird/werden.

14. Der Substratadapter nach Anspruch 13, **dadurch gekennzeichnet, dass** die dreidimensionalen Strukturen, insbesondere gleichmäßig beabstandet, entlang einer ersten Ausdehnungsachse, vorzugsweise entlang der ersten Ausdehnungsachse und einer zweiten Ausdehnungsachse angeordnet sind, insbesondere wobei die erste und die zweite Ausdehnungsachse in einem Winkel von im Wesentlichen 90° zueinander angeordnet sind.

15. Der Substratadapter nach einem der Ansprüche 11 bis 14, **dadurch gekennzeichnet, dass**
der Träger zumindest eine Klebeschicht, insbesondere eine Klebeschicht mit einer im Wesentlichen gleichbleibenden Klebekraft über die Oberfläche des Trägers umfasst, und/oder
die Kontaktierungsmaterial-Schicht einen Kleber, ein Lot und/oder ein Sintermaterial umfasst, insbesondere eine Sinterpaste und/oder eine Sinterfolie, die vorzugsweise Silber, eine Silberlegierung, Kupfer, und/oder einer Kupferlegierung umfasst/umfassen.
